# EUROPÄISCHE PATENTSCHRIFT

(11) **EP 0 475 175 B1**
(45) Veröffentlichungstag und Bekanntmachung des Hinweises auf die Patenterteilung: **13.04.1994**
(21) Anmeldenummer: 91114254.5
(22) Anmeldetag: 26.08.1991
(51) Int. Cl.: H05K 7/14, H01R 23/68

(54) **Rückwandverdrahtung**
Back panel connection
Connection à la paroi arrière

(30) Priorität: 11.09.1990 DE 9012949 U
(43) Veröffentlichungstag der Anmeldung: 18.03.1992
(73) Patentinhaber: SIEMENS AKTIENGESELLSCHAFT, 80333 München (DE)
(72) Erfinder: Thom, Günter, W-8035 Gauting (DE); Zell, Karl, Dipl.-Ing., W-8130 Niederpöcking (DE)

(56) Entgegenhaltungen:
- EP-A- 0 195 955
- EP-A- 0 203 404
- US-A- 4 550 362
- ELECTRONIC ENGINEERING. Bd. 57, Nr. 699, März 1985, LONDON GB, Seite 116;'Schroff speeds up back-plane connection'

## Beschreibung

Die Erfindung betrifft eine Rückwandverdrahtung für Steckvorrichtungen mit Aufnahmekammern für Kontaktfedern zum Aufstecken auf die Kontaktmesser einer Rückwandleiterplatte, wobei die Steckvorrichtung fest mit einer Baugruppenleiterplatte verbunden ist. Siehe beispielsweise die EP-A-0 203 404.

Derartige Rückwandverdrahtungen dienen in Baugruppenschränken zur Verbindung der einzelnen Baugruppen untereinander. Bekannte Rückwandverdrahtungen weisen ein Grundraster von 2,5 mm auf, in welchem die Kontaktmesser auf der Platte angeordnet sind. Die einzelnen Kontaktmesser sind mittels Multilayer-Anordnung miteinander verbunden. In vielen Fällen ist auch ein Stecken von Baugruppen auf beiden Seiten der Rückwandleiterplatte möglich. Aufgrund der hohen steckpunktdichte der Kontaktmesser sind, um eine Ausnutzung der Rückwandleiterplatte zu gewährleisten, die einzelnen Steckvorrichtungen sehr eng benachbart. Dabei kann es sowohl zu kapazitiven als auch induktiven Verkopplungen zwischen den einzelnen Steckvorrichtungen kommen, wodurch die Übertragungsgüte der zu übertragenden elektrischen Signale beeinträchtigt wird, und es zu Fehlschaltungen auf den einzelnen Baugruppen kommen kann.

Aufgabe der vorliegenden Erfindung ist es, eine Rückwandverdrahtung der eingangs genannten Art anzugeben, bei der die einzelnen Steckvorrichtungen sowohl kapazitiv als auch induktiv entkoppelt sind.

Diese Aufgabe wird für eine Rückwandverdrahtung der oben genannten Art dadurch gelöst, daß auf die Kontaktmesser einseitig offene rechtwinkelige metallene Schirmgehäuse zur Aufnahme der Steckvorrichtungen derart aufschiebbar sind, daß über Preßverbindungen ein Teil der Kontaktmesser fest mit einem Schirmgehäuse verbunden ist, während die übrigen Kontaktmesser durch Freilöcher in die Schirmgehäuse hineinragen, wobei die Aufnahmekammern der Steckvorrichtungen, in welche die mit dem Schirmgehäuse festverbundenen Kontaktmesser hineinragen, nicht mit Kontaktfedern belegt sind.

Dadurch, daß die einzelnen Steckvorrichtungen von einseitig offenen rechtwinkeligen metallenen Schirmgehäusen umgeben sind, welche mit Erdpotential verbunden sind, wird erreicht, daß auch eng benachbarte Steckvorrichtungen sowohl kapazitiv als induktiv wirksam entkoppelt sind. Auf diese Weise wird eine gegenseitige Beeinflussung der Baugruppen verhindert.

Eine zweckmäßige Ausgestaltung der erfindungsgemäßen Rückwandverdrahtung ist dadurch gekennzeichnet, daß die Innenabmessungen des Schirmgehäuses den Außenabmessungen der Steckvorrichtung entsprechen. Auf diese Weise wird eine unnötige Platzbelegung auf der Rückwandleiterplatte vermieden.

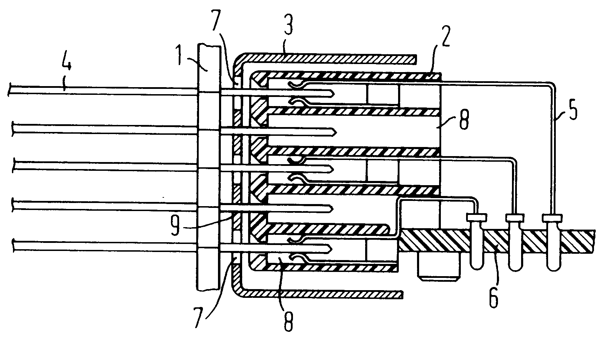

Im folgenden wird die Erfindung anhand eines in der Zeichnung dargestellten Ausführungsbeispiels näher erläutert.

Die Figur zeigt einen teilweisen Querschnitt durch eine Rückwandverdahtung gemäß der vorliegenden Erfindung. Bei der dargestellten Rückwandverdrahtung ist die Rückwandleiterplatte 1 auf ihrem überwiegenden Teil mit Kontaktmessern 4 in einem Grundraster von 2,5 mm belegt. Auf die Kontaktmesser können mit Baugruppenleiterplatten 6 festverbundene Steckvorrichtungen, auch Federleisten 2 genannt, aufgesteckt werden. Die Federleiste 2 verfügt über Aufnahmekammern 8 zur Aufnahme der Kontaktfedern 5, die den eigentlichen Kontakt mit den Kontaktmessern 4 bilden. Die einzelnen Kontaktfedern 5 sind mit nicht dargestellten Leiterbahnen der Baugruppenleiterplatte 6 verbunden.

Zur kapazitiven und induktiven Entkopplung benachbachbarter Federleisten 2 ist erfindungsgemäß das einseitig offene rechtwinkelige metallene Schirmgehäuse 3 vorgesehen. Im Boden des Schirmgehäuses 3 sind sowohl Freilöcher 7 als auch Preßverbindungen 9 vorgesehen. Die Preßverbindungen 9 sind überall da vorgesehen, wo ein Kontakt des Schirmghäuses 3 mit einem erdpotentialführenden Kontaktmesser 4 erfolgen soll. Üblicherweise sind bei einer Rückwandverdrahtung gemäß der Erfindung die Aufnahmekammern 8 der Federleisten 2 nicht belegt, in welche die erdpotentialführenden Kontaktmesser 4 hineinragen.

Um den Platzbedarf auf der Rückwandleiterplatte 1 mäglichst gering zu halten, ist es nötig die Innenabmessungen der Schirmgehäuse 3 den Außenabmessungen der Steckvorrichtung 2 anzupassen.

Bei der dargestellten Rückwandverdrahtung ist es auch denkbar, daß die erdpotentialführenden Kontaktmesser 4 im einzelnen so angeordnet werden, daß bestimmte Kontaktmesser bzw. Kontaktfedern einzeln oder in Gruppen untereinander sowohl induktiv als auch kapazitiv entkoppelt sind.

## Patentansprüche

1. Anordnung einer Rückwandverdrahtung und Steckvorrichtungen mit Aufnahmekammern für Kontaktfedern zum Aufstecken auf die Kontaktmesser einer Rückwandleiterplatte, und Steckvorrichtungen, die fest mit einer Baugruppenleiterplatte verbunden sind,
**dadurch gekennzeichnet**, daß auf die Kontaktmesser (4) einseitig offene rechtwinkelige metallene Schirmgehäuse (3) zur Aufnahme der Steckvorrichtungen (2) derart aufgeschoben sind, daß über Preßverbindungen (9) ein Teil der Kontaktmesser (4) fest mit einem Schirmgehäuse (3) verbunden ist, während die übrigen Kontaktmesser (4) durch Freilöcher (7) in die Schirmgehäuse (3) hineinragen, wobei die Aufnahmekammern (8) der Steckvorrichtungen (2), in welche die mit dem Schirmgehäuse (3) festverbundenen Kontaktmesser (4) hineinragen, nicht mit Kontaktfedern (5) belegt sind.

2. Anordnung nach Anspruch 1,
**dadurch gekennzeichnet**, daß die Innenabmessungen des Schirmgehäuses (3) den Außenabmessungen der Steckvorrichtung (2) entsprechen.

## Claims

1. Backplane wiring system and plug devices having receiving chambers for spring contacts for plugging on to the contact blades of a backplane printed circuit board, and plug devices which are firmly connected to an assembly printed circuit board, characterized in that rectangular metallic shielding housings (3) designed to receive the plug devices (2) and open on one side are pushed on to the contact blades (4) in such a way that some of the contact blades (4) are firmly connected to a shielding housing (3) by means of press-fit connections (9), while the remaining contact blades (4) project into the shielding housings (3) through clearance holes (7), those receiving chambers (8) of the plug devices (2) into which the contact blades (4) firmly connected to the shielding housing (3) project not being fitted with spring contacts.

2. System according to Claim 1, characterized in that the internal dimensions of the shielding housing (3) match the external dimensions of the plug device (2)

## Revendications

1. Dispositif comprenant un câblage de paroi arrière et des connecteurs comportant des chambres de réception de ressorts de contact, pour l'enfichage sur les couteaux de contact d'une plaque de conducteurs de paroi arrière, et des dispositifs à enfichage qui sont reliés rididement à une plaquette à circuits imprimés porte-modules, caractérisé par le fait que des boîtiers de blindage (3) métalliques, rectangulaires, ouverts d'un côté et destiné à recevoir les dispositifs à enfichage (2) sont emmanchés sur les couteaux de contact (4) de telle sorte qu'une partie des couteaux de contact (4) est reliée de façon rigide par l'intermédiaire de liaisons à serrage (9) à un boîtier de blindage (3), tandis que les autres couteaux de contact (4) traversent des trous traversants (7) ménagés dans le boîtier de blindage (3), les chambres de réception (8) des dispositifs à enfichage (2), dans lesquelles pénètrent les couteaux de contact (4) reliés rigidement au bottier de blindage (3), n'étant pas occupées par des ressorts de contact (5).

2. Dispositif suivant la revendication 1, caractérisé par le fait que les dimensions intérieures du bottier de blindage (3) correspondent aux dimensions extérieures du dispositif à enfichage (2).
